# DEMANDE DE BREVET EUROPEEN

(11) **EP 0 698 951 A1**
(43) Date de publication de la demande: **28.02.1996**
(21) Numéro de dépôt: 95401926.1
(22) Date de dépôt: 22.08.1995
(51) Int. Cl.: H01S 3/085, G02F 1/015

(54) **Composant optique, optoélectronique ou photonique comportant au moins une cavité optique confinée latéralement et procédé pour sa réalisation**

(30) Priorité: 23.08.1994 FR 9410216
(71) Demandeur: FRANCE TELECOM, F-75015 Paris (FR)
(72) Inventeur: Abram, Izo, F-92210 Saint-Cloud (FR)
(74) Mandataire: Ahner, Francis

(57) **Abrégé**

Le composant optique, optoélectronique ou photonique comporte, pour une longueur d'onde de fonctionnement donnée, au moins une cavité optique (2a) qui est définie entre deux réflecteurs (3,4), ladite cavité optique (2a) étant confinée latéralement. Lesdits réflecteurs (3,4) sont du type à changement de phase et la zone (2a) entre lesdits réflecteurs (3,4) qui correpond à la cavité optique présente une longueur d'onde de coupure qui est supérieure à la longueur d'onde de coupure de la zone (2b) qui l'entoure latéralement, la longueur d'onde de fonctionnement étant comprise entre ces deux longueurs d'onde de coupure.

Le procédé permet la réalisation d'un tel composant en mettant en oeuvre une gravure peu profonde.

## Description

La présente invention est relative aux composants optiques, optoélectroniques ou photoniques, du type comportant au moins une cavité optique à confinement latéral. Elle concerne également un procédé pour la réalisation d'un tel composant.

Les cavités optiques confinées des composants conformes à l'invention sont par exemple utilisées pour réaliser sur ces composants des lasers, des photodétecteurs, des éléments de mémoire, de commutation, ou de logique optique.

L'invention trouve par conséquent avantageusement application dans le domaine des télécommunications optiques pour l'émission, la détection ou le traitement de signaux.

Le fonctionnement de plusieurs composants optiques et optoélectroniques nécessite une cavité optique constituée généralement par deux surfaces planes réfléchissantes, mutuellement parallèles. Cette configuration géométrique renforce le champ lumineux à l'intérieur de la cavité, à cause de son confinement unidimensionnel entre les deux surfaces réfléchissantes. La cavité optique est indispensable, en particulier, au fonctionnement des lasers ou des bistables optiques, alors que d'autres composants, pouvant fonctionner sans cavité, tels que les photodétecteurs, voient leurs performances améliorées lorsqu'ils sont placés à l'intérieur d'une cavité optique.

A titre d'exemple représentatif de composants optoélectroniques mettant en jeu une cavité optique, citons les lasers à semiconducteur planaires émettant par la surface (Vertical Cavity Surface Emitting Lasers, VCSELs), qui sont actuellement disponibles commercialement. Ces composants consistent en un empilement de trois groupes de couches minces de semiconducteur, déposés par les méthodes classiques de croissance cristalline sur un substrat semiconducteur. Le premier groupe de couches déposé sur le substrat constitue un miroir de Bragg, le second réalise la cavité laser, alors que le troisième constitue le miroir de Bragg supérieur de la cavité. La lumière est émise et amplifiée par des couches actives excitées électriquement ou optiquement, situées dans le deuxième groupe, et elle sort perpendiculairement au plan de la cavité vers l'extérieur à travers le miroir de Bragg supérieur.

Il est souvent nécessaire de délimiter latéralement l'extension des composants à cavité optique en vue de la miniaturisation et l'intégration d'un grand nombre de composants sur un même substrat. Par exemple, des composants individuels de dimensions latérales de l'ordre de quelques dizaines de microns, peuvent constituer une matrice de "pixels" (abréviation anglaise de PICTure ELement) c'est-à-dire des éléments ponctuels juxtaposés dont le fonctionnement concerté permet le traitement ou la visualisation d'images. La délimitation latérale d'une cavité à plus courte échelle peut renforcer le champ lumineux sur l'élément actif du composant, en imposant un confinement optique également selon le plan de la cavité. En particulier, une délimitation latérale de dimensions comparables à quelques longueurs d'onde optiques permet d'éliminer des modes transverses d'ordre supérieur de la cavité optique, dont la présence pourrait compromettre le fonctionnement de certains composants. Finalement, des dimensions latérales de l'ordre d'une longueur d'onde optique permettent d'éliminer tous les modes transverses d'ordre supérieur et d'atteindre un fonctionnement monomode de la cavité, résultant par exemple à une émission laser monofréquence.

Dans toute la suite du présent texte, la terminologie "résonateur optique" ou "microrésonateur optique" désigne une telle cavité optique monomode et monofréquence.

La délimitation latérale des résonateurs optiques à semiconducteur s'effectue couramment selon un procédé utilisant les techniques de gravure de plots (mesas) mises au point pour la technologie des composants électroniques. Selon ce procédé, une fois que la cavité planaire est fabriquée par déposition des trois groupes de couches minces de semiconducteur, elle est couverte par un masque qui protège les parties destinées à constituer le composant. Les parties non protégées sont alors attaquées par des composés chimiques ou des ions réactifs et sont éliminées. Après enlèvement du masque, le composant reste sous forme d'un plot avec des flancs relativement verticaux (mesa) traversant tous les trois groupes de couches.

Une deuxième méthode de délimitation latérale optique est le procédé dit de mélange d'alliage. Selon ce procédé, après déposition du masque, des défauts cristallins sont introduits dans les parties exposées de l'échantillon par bombardement ionique ou par des contraintes provoquées par un dépôt de silice et le matériau est par la suite recuit. Les défauts cristallins détruisent la structure en multicouches de l'échantillon, produisant un alliage des différents semiconducteurs qui constituent les couches originelles. Les parties intactes, stratifiées, constituant le composant, se délimitent par l'interface qui les sépare des parties désordonnées "extérieures".

Les méthodes de délimitation latérale utilisées actuellement pour définir les composants optoélectroniques présentent plusieurs difficultés techniques qui compliquent leur mise en oeuvre et les empêchent d'atteindre la miniaturisation ultime possible en optique, celle des dimensions de la longueur d'onde.

Les principaux inconvénients des composants à cavité définis par gravure de plots ou par mélange d'alliage sont les suivants :
(1) Du point de vue optique :
   Le confinement optique est relativement faible, car il est produit par la réflexion de la lumière à l'interface entre les parties protégées par le masque et les parties traitées. Cette réflexion est due à la différence d'indice de réfraction entre les deux régions et elle est, par conséquent, relativement faible. Pour des plots de semiconducteur gravés et exposés à l'air, le contraste d'indice est de l'ordre de 3, ce qui correspond à une réflectivité de l'ordre de 25 % seulement pour des surfaces planes, alors que dans le cas du mélange d'alliage, le contraste d'indice est de quelques pour cent (car il s'agit essentiellement des mêmes matériaux des deux côtés de l'interface) produisant un taux de réflexion généralement inférieur à 1 %.
(2) Du point de vue électronique :
   La structuration latérale profonde atteint les couches de semiconducteur qui sont actives dans l'émission de la lumière et dégrade leurs propriétés électroniques associées à l'émission lumineuse. En particulier, l'opération de gravure introduit des centres de recombinaison non radiative au voisinage des interfaces, ce qui réduit le rendement quantique d'émission, surtout pour des plots de petite taille. Dans certains cas, les défauts peuvent être guéris par des méthodes appropriées de passivation et de reprise de croissance cristalline, mais la mise en oeuvre de ces opérations complique considérablement le procédé de structuration latérale.
(3) Du point de vue mécanique et géométrique :
   Des plots de semiconducteur gravés sur une profondeur de quelques micromètres et de dimensions latérales de l'ordre d'une fraction de micromètre sont très fragiles mécaniquement, à cause du rapport d'aspect (= profondeur/largeur) important. De plus, le degré de verticalité des flancs nécessaire à un tel rapport d'aspect est très difficilement atteint lors de la gravure. Ces difficultés mécaniques et géométriques impliquent que le procédé de délimitation latérale des cavités à semiconducteur planaires par gravure de plots traversant les trois groupes de couches, ne permet pas la réalisation de cavités de dimensions latérales comparables à la longueur d'onde.

L'invention a pour but de pallier ces inconvénients.

A cet effet, l'invention propose d'utiliser les propriétés des cavités optiques définies par deux miroirs qui produisent, lors de la réflexion, un changement de phase de π radians sur le champ réfléchi. De tels miroirs sont par exemple des miroirs métalliques ou des miroirs de Bragg d'indice de réfraction supérieur à l'indice dans la cavité.

Une caractéristique spécifique des cavités formées par des réflecteurs à changement de phase est l'existence d'une longueur d'onde optique de coupure égale à deux fois l'épaisseur optique de la cavité (l'épaisseur optique étant définie comme le produit de l'épaisseur physique et de l'indice de réfraction). Les longueurs d'onde plus grandes que la longueur d'onde de coupure constituent la "bande interdite" de la cavité. En effet, un rayonnement lumineux dont la longueur d'onde est supérieure à la longueur d'onde de coupure ne peut être entretenu par la cavité : il sera donc complètement réfléchi en dehors de la cavité, alors qu'il sera évanescent à son intérieur.

Ces phénomènes d'inhibition sont connus de l'Homme du Métier et rapportés dans certaines publications. On pourra à cet égard avantageusement se référer aux articles suivants :
- "Cavity quantum electodynamics at optical frequencies" - S.E. Morin, Q. WU, T.W. Mossberg - Optics and Photonics News - August 1992 - p10-14 et plus particulièrement p11 ;
- "Spontaneous and stimulated emission in the threholdless microlaser" - F. de Martini, M. Marrocco, P. Mataloni, D. Murra, R. Loudon - J. Opt. Soc. Am. B- Vol. 10, N°2 - Feb. 1993 p360-380.

Plus particulièrement, le composant proposé par l'invention est un composant optique, optoélectronique ou photonique comportant, pour une longueur d'onde de fonctionnement donnée, au moins une cavité optique qui est définie entre deux réflecteurs, ladite cavité optique étant confinée latéralement, ledit composant étant caractérisé en ce que lesdits réflecteurs sont du type à changement de phase et en ce que la zone entre lesdits réflecteurs qui correpond à la cavité optique présente une longueur d'onde de coupure qui est supérieure à la longueur d'onde de coupure de la zone qui l'entoure latéralement, la longueur d'onde de fonctionnement étant comprise entre ces deux longueurs d'onde de coupure.

Ainsi que cela ressortira plus loin de la description détaillée de l'invention, le confinement optique latéral que présente la cavité d'un tel composant est de 100 % et est donc beaucoup plus efficace que les confinements obtenus dans l'art antérieur.

En outre, une telle structure de composant est particulièrement adaptée à la miniaturisation ultime et en particulier à la réalisation de résonateurs optiques présentant des dimensions comparables à la longueur d'onde optique.

Un tel résonateur présente un confinement optique important dans les trois directions de l'espace, sur une échelle de l'ordre de la longueur d'onde optique, modifiant ainsi l'émission spontanée des couches actives. Il trouve, par conséquent, avantageusement application dans la réalisation de lasers à semiconducteur monofréquences, de très bas seuil et d'efficacité élevée.

Selon un mode de réalisation particulièrement avantageux, la zone entre les deux réflecteurs qui correspond à la cavité optique et la zone qui l'entoure latéralement sont constituées dans un même matériau, l'épaisseur de la zone qui correspond à la cavité optique étant supérieure à celle de la zone qui l'entoure latéralement.

L'invention propose un procédé pour la réalisation d'un tel composant. Ce procédé est caractérisé par la succession d'étapes suivantes :
- on dépose sur un premier réflecteur une couche du matériau formant cavité,
- on dépose un masque sur cette couche, ou sur une couche rapportée qui l'encapsule,
- on bombarde ce masque et les zones non protégées de ladite couche ou de la couche rapportée, par des ions actifs qui réalisent une gravure peu profonde sur lesdites zones non protégées,
- on enlève le masque,
- on dépose le deuxième réflecteur.

On notera que puisque la gravure mise en oeuvre est peu profonde, elle n'atteint pas la couche active de la cavité et ne dégrade pas, par conséquent, ses caractéristiques électriques et optiques.

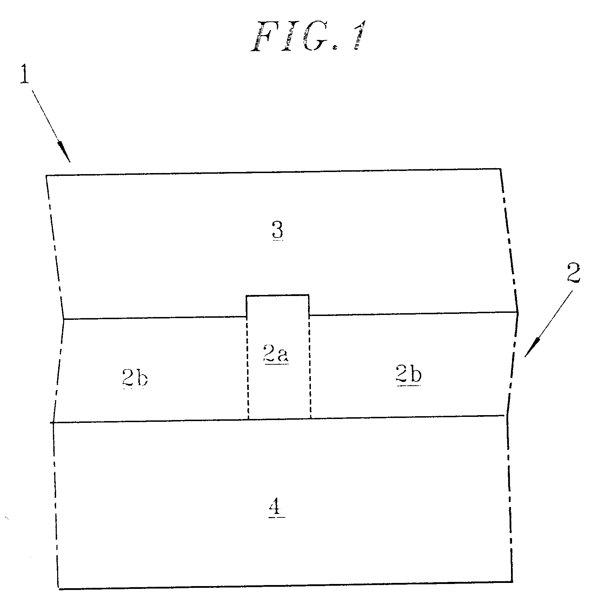

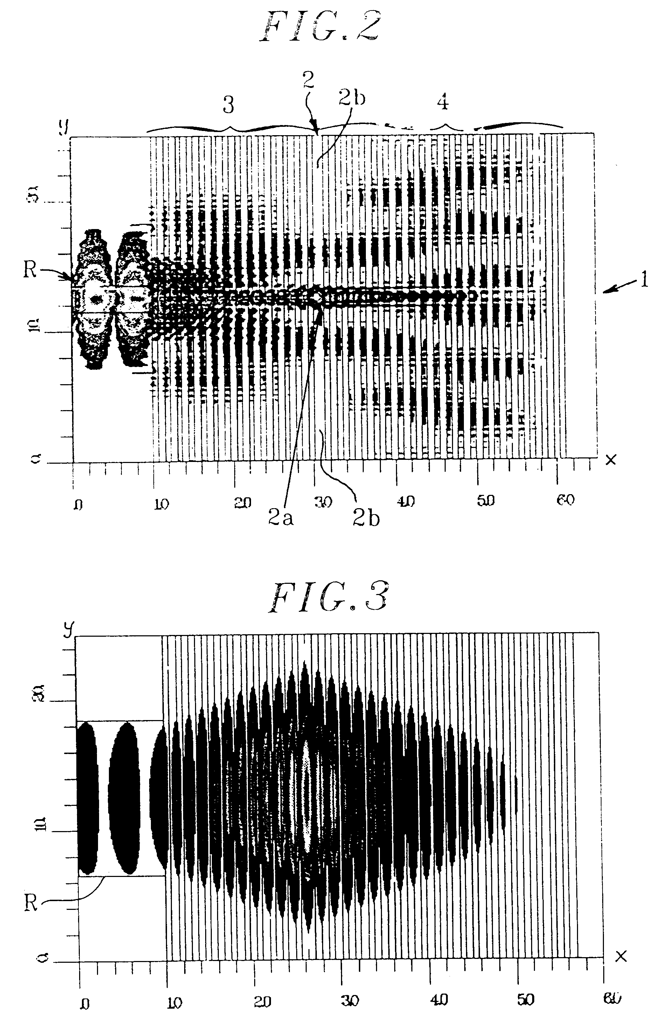

La description qui suit de l'invention est purement illustrative et non limitative. Elle doit être lue en regard des dessins annexés sur lesquels :
. la figure 1 représente schématiquement en coupe un composant conforme à l'invention ;
. la figure 2 est une représentation schématique en coupe de la structure d'empilement d'un composant conforme à l'invention, sur laquelle on a également représenté la répartition dans cette structure de l'intensité d'un rayonnement lumineux présentant une longueur d'onde correspondant au mode discret du résonateur dudit composant ;
. la figure 3 est une représentation semblable à celle de la figure 2 pour un composant qui est un empilement des mêmes matériaux du composant de la figure 2, cet empilement étant dépourvu de confinement

On a représenté schématiquement sur la figure 1 un composant 1 conforme à un mode de réalisation particulier de l'invention. Ce composant 1 est une plaquette constituée par l'empilement de trois groupes de couches minces (de semiconducteur, diélectriques ou métalliques) de manière à constituer une cavité plane 2 définie entre deux réflecteurs 3 et 4 à changement de phase.

La cavité plane 2 présente au moins deux parties :
- l'une, référencée par 2a, est une partie centrale qui présente une longueur d'onde de coupure de valeur λ_{c1} ;
- l'autre, référencée par 2b, entoure latéralement dans toutes les directions de la cavité plane 2, la partie centrale 2a. Cette partie latérale 2b présente une longueur d'onde de coupure λ_{c2} qui est légèrement plus courte que λ_{c1} (λ_{c2} < λ_{c1}).

Sur une telle plaquette 1, un rayonnement lumineux dont la longueur d 'onde λ se situe entre les deux longueurs d'onde de coupure (λ_{c2} < λ < λ_{c1}) ne peut être entretenu par la partie latérale 2b de courte longueur d'onde et est réfléchi vers la partie 2a de grande longueur d'onde de coupure.

En d'autres termes, une émission de lumière de longueur d'onde λ (λ_{c2} < λ < λ_{c1}) dans le composant 1 se trouve dans la bande interdite de la partie latérale 2b et est donc nécessairement confinée dans la partie centrale 2a par des réflexions totales dans toutes les directions.

On notera que le confinement ainsi réalisé est sans perte d'énergie : la partie latérale 2b qui délimite le confinement n'absorbe pas et ne transmet pas le rayonnement reçu. Toute l'énergie lumineuse est conservée dans la partie centrale 2a.

Le confinement optique obtenu est par conséquent de 100 % et est donc beaucoup plus efficace que les confinements optiques réalisés avec les techniques de l'art antérieur.

La diminution de la longueur d'onde de coupure de la partie latérale 2b par rapport à celle de la partie centrale 2a s'obtient en diminuant localement de quelques couches l'épaisseur optique de la cavité 2, soit par modification de l'indice de réfraction au niveau de cette partie 2b, soit préférentiellement, ainsi qu'illustré sur la figure 1, par diminution de l'épaisseur physique du groupe de couches constituant la cavité 2 au niveau de la partie 2b.

La diminution locale de l'épaisseur physique de la cavité 2 se réalise avantageusement en mettant en oeuvre les techniques de gravure sur composant, qui sont classiques pour l'Homme du Métier, et par exemple en mettant en oeuvre des procédés analogues à celui dont fait état l'article :
- "Reduced threshold all-optical bistability in etched quantum well microresonators " - T. Rivera, F.R. Ladan, A. Izraël, R. Azoulay, R. Kuszelewicz and J.L. Oudar - Appl. Phys. Lett. - 64(7) - Feb. 1994 - p869-871.

La gravure réalisée est peu profonde de sorte qu'elle n'atteint pas (et, par conséquent, n'endommage pas) la couche active émettrice de lumière alors qu'elle conserve un rapport d'aspect de gravure (profondeur/largeur) généralement inférieur à 1. Ce faible rapport d'aspect assure une bonne définition géométrique et une grande stabilité mécanique de composants de taille même inférieure à la longueur d'onde.

L'invention permet de réaliser des composants 1 présentant des cavités optiques 2a de dimensions inférieures à la longueur d'onde, et rend par conséquent possible la réalisation de microrésonateurs optiques essentiellement monomodes, avec fort confinement du champ lumineux.

La réalisation de résonateurs monomodes présente des avantages importants pour la réalisation de composants optoélectroniques, et notamment pour la réalisation de microcomposants lasers.

On pourra à cet égard avantageusement se référer à la publication :
- "Optical processes in microcavities" - Y. Yamamoto, R. E. Slusher - Physics today - June 1993 - American Institute of Physics - p66-73,
dont l'enseignement est ici inclus par référence.

En particulier, la grande sélectivité en fréquences de ces résonateurs peut être utilisée pour la réalisation de lasers monofréquences.

Le confinement important du champ à l'intérieur d'un tel microrésonateur modifie les propriétés d'émission spontanée des couches actives permettant ainsi un abaissement important du seuil de l'émission laser.

De plus, la taille de ces microrésonateurs, comparable à la longueur d'onde lumineuse, correspond à la miniaturisation ultime des composants optoélectroniques imposée par les lois de diffraction de la lumière.

En outre, le procédé de réalisation proposé par l'invention se prête bien, d'une part, à la constitution de matrices de tels résonateurs pour la mise en oeuvre de traitements en parallèle, et, d'autre part, à l'intégration de plusieurs composants élémentaires sur un même substrat, ce qui permet d'envisager la réalisation de circuits optoélectroniques intégrés de dimensions minimales (les dimensions limites étant imposées par la diffraction de la lumière).

De façon plus générale, l'inclusion dans les microrésonateurs proposés par l'invention de matériaux présentant des propriétés optiques ou optoélectroniques adéquates permet la réalisation de composants spécifiques, et notamment, outre les microlasers, des composants photodétecteurs, ou des éléments de mémoire, de commutation ou de logique optique.

On va maintenant décrire de façon détaillée un exemple de composant réalisé à partir de deux matériaux semiconducteurs communément utilisés pour la réalisation de composants électroniques et optoélectroniques, à savoir GaAs et AlAs.

Bien entendu, d'autres matériaux sont envisageables. En particulier, l'utilisation de couples de matériaux de plus fort contraste d'indice de réfraction ou de couches métalliques pour constituer les miroirs produirait un meilleur confinement du champ lumineux perpendiculairement au plan des couches.

Une structure stratifiée constituée de couches alternées de GaAs et AlAs est dans un premier temps fabriquée par les méthodes habituelles de croissance cristalline de ces matériaux sur substrat de GaAs, à savoir par épitaxie par jet moléculaire ou par déposition de composés organométalliques en phase vapeur.

Cette structure comprend deux groupes de couches:
- le premier groupe est une alternance de 20 couches AlAs et GaAs d'épaisseur 81.1 nm et 67.8 nm respectivement, correspondant à un miroir de Bragg dont la bande de réflectivité est centrée à la longueur d'onde de 960 nm ;
- le deuxième groupe est constitué d'une couche de Al_{0.9}Ga_{0.1}As (comprenant éventuellement un puits quantique par exemple en In_{0.15}Ga_{0.85}As au centre) de 190 nm d'épaisseur (correspondant à une cavité demi-onde λ/2 à 986 nm) et une couche fine de 20 nm pour encapsuler temporairement la couche constituant la cavité.

Un masque est ensuite déposé sur le deuxième groupe de couches. Ce masque délimite des disques d'un diamètre de 320 nm, disposés éventuellement en matrice de M sur N unités.

Le masque et les zones découvertes de la deuxième couche sont bombardés par des ions réactifs, pour graver sur une profondeur de 80nm lesdites zones non protégées par ledit masque, afin de réduire, au niveau de ces zones, la couche constituant la cavité à une épaisseur de 130 nm.

Une fois le masque enlevé, l'échantillon peut être réintroduit dans l'appareil d'épitaxie pour reprendre la croissance cristalline (en enlevant préalablement la couche d'encapsulation) en déposant un troisième groupe de couches, constitué d'une alternance de 13 paires GaAs et AlAs correspondant au miroir supérieur de la cavité.

Cette dernière étape peut également être remplacée ou complétée par un ou des dépôts de couches métalliques. Les miroirs métalliques présentent un grand avantage pour les composants excités électriquement, car ils sont conducteurs et peuvent constituer l'une des électrodes d'excitation. De plus, à cause de la faible pénétration du champ dans de tels miroirs, le confinement du champ dans la cavité est plus important et, par conséquent, une gravure moins profonde peut produire le même changement de la longueur d'onde de coupure que dans le cas des miroirs en multicouches.

Le microrésonateur fabriqué de la façon qui vient d'être décrite a été représenté schématiquement en coupe sur la figure 2. On a repris sur cette figure 2 les mêmes numérotations de référence que sur la figure 1.

Avec les valeurs numériques indiquées, ce microrésonateur présente un mode discret de longueur d'onde de 960 nm, détaché nettement du continuum qui commence à 935 nm.

Ainsi qu'illustré par la répartition des zones d'iso-intensité représentée sur la figure 2, un rayonnement R correspondant au mode discret précité et envoyé sur le composant 1 perpendiculairement aux plans de ses couches, se retrouve confiné latéralement dans le plan de la cavité 2, au niveau de la partie centrale 2a : il est localisé sous le disque défini par la gravure (partie 2a), alors qu'il est évanescent dans la partie traitée (partie 2b) dans laquelle il ne pénétre que sur une longueur de 300 nm.

Le confinement du champ, selon l'axe de la cavité, se fait par la réflexion sur les deux miroirs de Bragg 3 et 4 ; le champ est donc maximal sur la couche de AlAs ("λ/2") et décroissant dans les miroirs de Bragg sur une longueur de l'ordre de 300 nm. L'émission de lumière vers l'extérieur de la cavité se fait à travers les miroirs de Bragg 3 et 4.

La répartition de l'intensité lumineuse illustrée sur la figure 2 est à comparer à celle représentée sur la figure 3. Le rayonnement R' correspondant est analogue à celui de la figure 2. Le composant sur lequel il est envoyé est un empilement sans confinement des matériaux du composant de la figure 2.

On voit sur cette figure 3 que la largeur de la zone dans laquelle se répartit le rayonnement R' est principalement imposée par la géométrie du faisceau incident.

## Revendications

1. Composant optique, optoélectronique ou photonique comportant, pour une longueur d'onde (λ) de fonctionnement donnée, au moins une cavité optique (2a) qui est définie entre deux réflecteurs (3,4), ladite cavité optique (2a) étant confinée latéralement, caractérisé en ce que lesdits réflecteurs (3,4) sont du type à changement de phase et en ce que la zone (2a) entre lesdits réflecteurs (3,4) qui correspond à la cavité optique présente une longueur d'onde de coupure (λ_{c1}) qui est supérieure à la longueur d'onde de coupure (λ_{c2}) de la zone (2b) qui l'entoure latéralement, la longueur d'onde de fonctionnement (λ) étant comprise entre ces deux longueurs d'onde de coupure (λ_{c1} , λ_{c2}).

2. Composant selon la revendication 1, caractérisé en ce que l'épaisseur optique de la zone (2a) entre les deux réflecteurs (3,4) qui correspond à la cavité optique est supérieure à celle de la zone (2b) qui l'entoure latéralement.

3. Composant selon la revendication 2, caractérisé en ce que la zone (2a) entre les deux réflecteurs (3,4) qui correspond à la cavité optique et la zone (2b) qui l'entoure latéralement sont constituées dans un même matériau, l'épaisseur de la zone (2a) qui correspond à la cavité optique étant supérieure à celle de la zone (2b) qui l'entoure latéralement.

4. Composant selon la revendication 2, caractérisé en ce que l'épaisseur de la zone (2a) entre les deux réflecteurs (3,4) qui correspond à la cavité optique est identique à celle de la zone (2b) qui l'entoure latéralement, l'indice de réfraction de la zone (2a) qui correspond à la cavité optique étant supérieur à celui de la zone (2b) qui l'entoure latéralement.

5. Composant selon l'une des revendications précédentes, caractérisé en ce qu'au moins un des réflecteurs (3,4) comporte des couches métalliques.

6. Composant selon l'une des revendication 1 à 5, caractérisé en ce que les deux réflecteurs (3,4) sont des miroirs de Bragg.

7. Composant selon l'une des revendications précédentes, caractérisé en ce qu'il comporte une matrice de cavités optiques du type précité.

8. Composant selon l'une des revendications précédentes, caractérisé en ce que la zone (2a) entre les deux réflecteurs (3,4) qui correspond à la cavité optique présente des dimensions latérales qui sont inférieures à la longueur d'onde de fonctionnement, ladite cavité étant monomode.

9. Composant d'émission laser selon l'une des revendications précédentes.

10. Procédé pour la réalisation d'un composant selon la revendication 3, caractérisé par la succession d'étapes suivantes :
- on dépose sur un premier réflecteur (4) une couche (2) du matériau formant cavité,
- on dépose un masque sur cette couche, ou sur une couche rapportée qui l'encapsule,
- on bombarde ce masque et les zones non protégées (2b) de ladite couche ou de la couche rapportée, par des ions actifs qui réalisent une gravure peu profonde sur lesdites zones non protégées,
- on enlève le masque,
- on dépose le deuxième réflecteur (3).
